# EUROPEAN PATENT SPECIFICATION

(11) **EP 4 307 483 B1**
(45) Date of publication and mention of the grant of the patent: **02.09.2026**
(21) Application number: 23213847.9
(22) Date of filing: 04.03.2019
(51) Int. Cl.: H01Q 1/24, H01Q 21/00, H01Q 21/28

(54) **MILLIMETER-WAVE ASSEMBLY**
MILLIMETERWELLENANORDNUNG
ENSEMBLE À ONDES MILLIMÉTRIQUES

(43) Date of publication of application: 17.01.2024
(62) Document number(s) of the earlier application(s) in accordance with Art. 76 EPC: 19709429.5 / 3 903 378
(73) Proprietor: Huawei Technologies Co., Ltd., Shenzhen, Guangdong 518129 (CN)
(72) Inventor: KHRIPKOV, Alexander, Shenzhen, 518129 (CN); LIU, Dong, Shenzhen, 518129 (CN); ILVONEN, Janne, Shenzhen, 518129 (CN); OU, Jian, Shenzhen, 518129 (CN); TIAN, Ruiyuan, Shenzhen, 518129 (CN); XU, Changnian, Shenzhen, 518129 (CN); HUANG, Wei, Shenzhen, 518129 (CN); MILOSAVLJEVIC, Zlatoljub, Shenzhen, 518129 (CN); VAN WONTERGHEM, Jari, Kristian, Shenzhen, 518129 (CN)
(74) Representative: MERH-IP Matias Erny Reichl Hoffmann Patentanwälte PartG mbB

(56) References cited:
- EP-A1- 3 444 894
- KR-A- 20110 131 750
- US-A1- 2016 351 998

## Description

### TECHNICAL FIELD

The disclosure relates to a millimeter-wave (mmWave) assembly comprising a first mmWave module, a second mmWave module, and a connector configured to interconnect the first mmWave module and the second mmWave module.

### BACKGROUND

Electronic devices need to support more and more radio signal technology such as 2G/3G/4G radio. For coming 5G radio technology, the frequency range will be expanded from sub-6 GHz to so called millimeter-wave (mmWave) frequency, e.g. above 20 GHz. For mmWave frequencies, an antenna array will be necessary in order to form a radiation beam with higher gain which overcomes the higher path loss in the propagation media. However, radiation beam patterns with higher gain result in a narrow beam width, wherefore beam steering techniques such as the phased antenna array is used to steer the beam in a specific, desired direction.

Mobile electronic devices, such as mobile phones and tablets, may be oriented in any arbitrary direction. Therefore, such electronic devices need to exhibit an as near full spherical beam coverage as possible. Such coverage is difficult to achieve, i.a. due to the radiation beam being blocked by a conductive housing, a large display, and/or by the hand of the user holding the device.

Conventionally, a mmWave antenna array is arranged next to the display, such that the display does not interfere with the beam coverage. However, the movement towards very large displays, covering as much as possible of the electronic device, makes the space available for the antenna array very limited, forcing either the size of the antenna array to be significantly reduced, and its performance impaired, or a large part of the display to be inactive.

The limited antenna space makes implementing a mmWave antenna array, while getting sufficient beam coverage, difficult. There is not enough space on the display side for a conventional mmWave antenna array in the same module together with the radiofrequency (RF) active circuit circuitry. One solution to this problem is to implement a distributed antenna array, where the mmWave antenna array is arranged in a mechanically separate part other than the RF active circuit circuitry. This allows placing the mmWave antenna within the display clearance while allowing the RF active circuit to be located further away, where there is space.

Document US 2016/351998 A1 discloses an electronic device that includes a front cover forming a front surface, a rear cover forming a rear surface, a sidewall at least partially enclosing a space formed between the front cover and the rear cover and at least partially formed of a conductive member, a display disposed in the space and including a screen region exposed through the front cover, a non-conductive structure disposed in adjacent to the sidewall or in contact with the sidewall in the space and including a first surface facing the front cover and a second surface facing the rear cover, a first antenna pattern overlapping the non-conductive structure and fed with electricity, a second antenna pattern overlapping the non-conductive structure and disposed adjacent to the first antenna pattern to form electromagnetic-field coupling with the first antenna pattern, and an integrated circuit chip feeding electricity to the first antenna pattern.

KR 2011 0131750 A discloses a portable terminal. In particular, an antenna unit transmits and receives an electro magnetic wave corresponding to a wireless signal. A flexible logic circuit board is connected with a main circuit board and the antenna unit in order to form the transmission route of the wireless signal. A first switch is installed at the flexible logic circuit board. The first switch unit is selectively connected to the connection terminal of an external terminal. The first switch changes the transmission route in order to transmit the wireless signal to the external apparatus.

### SUMMARY

According to a first aspect, there is provided an electronic device according to claim 1.

This solution allows an mmWave assembly which has a small footprint while still having sufficient radiofrequency performance. Furthermore, the mmWave assembly facilitates assembly and repair, by dividing the assembly into at least two, repeatedly attachable and detachable, parts. Additionally, the detachability allows the mmWave assembly to use any available space within the electronic device.

According to a second aspect, there is provided a method of assembling the electronic device according to claim 10.

In a possible implementation form of the second aspect, the connector further comprises a second connector element, associated with the second mmWave module, the first mmWave module engaging with the second mmWave module by means of the first connector element engaging with the second connector element, allowing a range of suitable interconnecting elements to be used.

In a further possible implementation form of the second aspect, the first mmWave module engages with the second mmWave module by means of a third connector element, a first section of the third connector element engaging the first connector element and second section of the third connector element engaging the second connector element, allowing interconnecting sections to be arranged on a separate element.

This and other aspects will be apparent from the embodiments described below.

### BRIEF DESCRIPTION OF THE DRAWINGS

In the following detailed portion of the present disclosure, the aspects, embodiments and implementations will be explained in more detail with reference to the example embodiments shown in the drawings, in which:
Fig. 1 shows a schematic cross-sectional side view of a millimeter-wave assembly mounted in an electronic device in accordance with one embodiment of the present invention;
Fig. 2 shows a schematic cross-sectional side view of a millimeter-wave assembly mounted in an electronic device in accordance with a further embodiment of the present invention;
Fig. 3 shows a schematic cross-sectional side view of a millimeter-wave assembly mounted in an electronic device in accordance with yet another embodiment of the present invention;
Fig. 4 shows a schematic cross-sectional side view of a millimeter-wave assembly mounted in an electronic device in accordance with yet another embodiment of the present invention;
Fig. 5 shows a schematic cross-sectional side view of a millimeter-wave assembly mounted in an electronic device in accordance with yet another embodiment of the present invention;
Fig. 6 shows a schematic cross-sectional side view of a millimeter-wave assembly mounted in an electronic device in accordance with yet another embodiment of the present invention;
Fig. 7a shows a perspective view of a millimeter-wave assembly and an electronic device in accordance with one embodiment of the present invention;
Fig. 7b shows a perspective view of the embodiment of Fig. 7a, wherein the millimeter-wave assembly is mounted into the electronic device;
Fig. 8a shows a schematic side view of a millimeter-wave assembly in accordance with one embodiment of the present invention;
Fig. 8b shows a schematic side view of a millimeter-wave assembly in accordance with a further embodiment of the present invention;
Fig. 9 shows a schematic side view of a section of a millimeter-wave assembly in accordance with yet another embodiment of the present invention.

### DETAILED DESCRIPTION

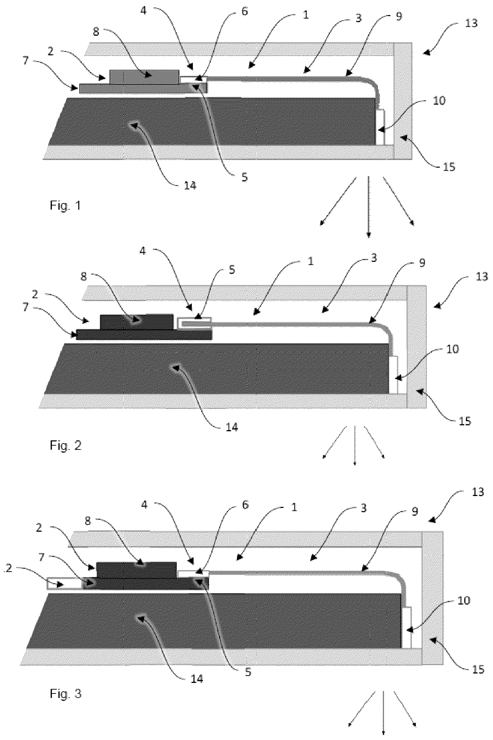

Figs. 1 to 7b show an electronic device 13 comprising a device chassis 14, a millimeter-Wave (mmWave) assembly 1, described in more detail further below, and a housing 15 enclosing the device chassis 14 and the mmWave assembly 1. The mmWave assembly 1 comprises at least a first mmWave module 2, a second mmWave module 3, and a connector 4 configured to releasably interconnect the first mmWave module 2 and the second mmWave module 3.

The first mmWave module 2 of the mmWave assembly 1 may be connected to the device chassis 14, or an internal component of the electronic device 13 such as a flexible or rigid printed circuit board (PCB). The flexible PCB may be a liquid crystal polymer (LCP) PCB.

In one embodiment, the mmWave assembly 1 comprises at least one mmWave antenna array 10, 12, each mmWave antenna array 10, 12 extending adjacent a face of the housing 15.

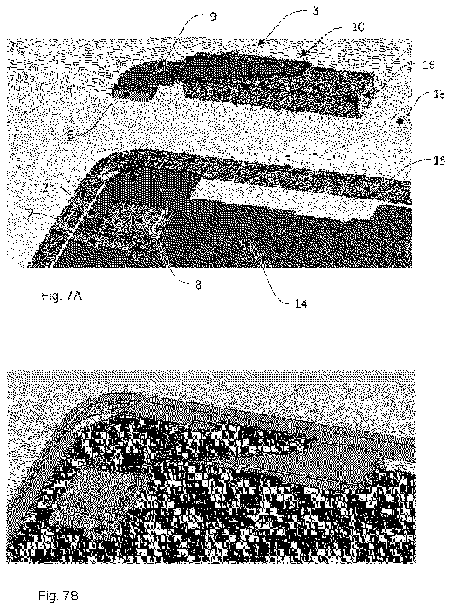

The present disclosure further relates to a method of assembling the electronic device 13 which, comprises a plurality of sequential, or nonsequential, steps. As shown in Fig. 7a, the first mmWave module 2 of the mmWave assembly 1 is connected to the device chassis 14. The second mmWave module 3 of the mmWave assembly 1 is connected to the device chassis 14, the housing 15, and/or an electromechanical module 16 arranged between the device chassis 14 and the housing 15, as also shown in Fig. 7a. The first mmWave module 2 engages with the second mmWave module 3, as shown in Fig. 7b, by means of a connector 4. In one embodiment, the second mmWave module 3 of the mmWave assembly 1 is connected to the electromechanical module 16. The electromechanical module 16 may be, e.g., a camera module.

As mentioned above, the millimeter-wave (mmWave) assembly 1 comprises a first mmWave module 2, a second mmWave module 3, and a connector 4 configured to releasably interconnect the first mmWave module 2 and the second mmWave module 3.

The connector 4 comprises at least a first connector element 5, associated with the first mmWave module 2. By "associated" is meant being connected by means of, e.g., screws, adhesive, soldering or similar.

The first mmWave module 2 comprises at least a first substrate 7 and a mmWave radiofrequency integrated circuit (RFIC) 8. The second mmWave module 3 comprises at least a second substrate 9 and a mmWave antenna array 10. At least one of the first substrate 7 and the second substrate 9 may be a flexible or rigid printed circuit board.

In one embodiment, the first mmWave module 2 comprises a further mmWave antenna array 12. mmWave antenna array 12 may be arranged such that it generates radiation in the same direction, or in different directions, than the radiation generated by mmWave antenna array 10.

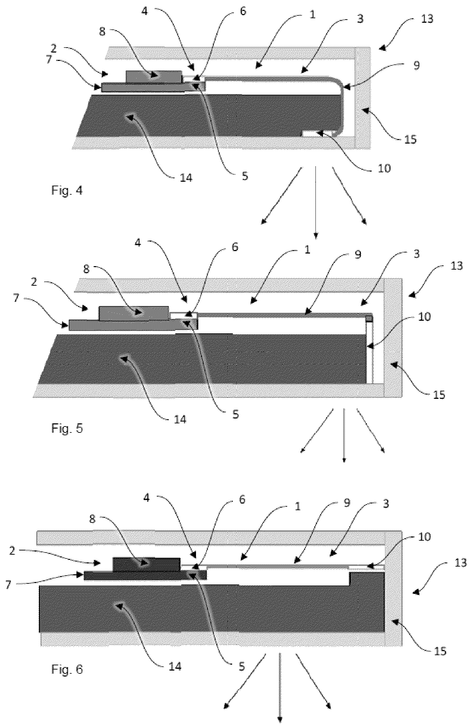

One or both of the mmWave antenna arrays 10, 12 may extend at an angle ≥ 0° to a main plane of the first substrate. mmWave antenna array 10 may extend essentially perpendicular, i.e. at 90°, to the main plane of the first substrate 7, as shown in Figs. 1 to 3 and 5. mmWave antenna array 10 may extend essentially parallel to the main plane of the first substrate 7, as shown in Figs. 4, showing a 180° angle, and 6, showing a 0° angle. mmWave antenna array 12 may extend essentially parallel to the main plane of the first substrate 7, and as shown in Fig.3, extend in the main plane of the first substrate 7.

The above-mentioned angle is achieved by means of either a bend in the second substrate 9, as shown in Figs. 1 to 4, or by means of the second substrate 9 and the mmWave antenna array 10 being split into separate elements, as shown in Fig. 5, the separate elements being fixedly interconnected by means of, e.g., soldering or being releasably interconnected by means of the galvanic or non-galvanic connections described further below. The angle may also be achieved by means of a plurality of bends, e.g. two 45° bends (not shown).

Each antenna array 10, 12 may be arranged such that one end of the array is located closer to the first substrate 7 than the other end of the array. Furthermore, each antenna array 10, 12 may be arranged such that one end of the array is located closer to the second substrate 9 than the other end of the array. The distance between the respective ends of the array, and the first and/or second substrate, may be seen in any direction, including directions perpendicular to, and parallel with, a main plane of the first substrate 7 and/or the second substrate 9. One or both mmWave antenna arrays 10, 12 may be offset in at least one direction in relation to the main plane of the first substrate 7 and/or the second substrate 9. As shown in Figs. 4 and 6, the antenna arrays 10, 12 may extend parallel to the main plane of the first substrate 7, but at a distance from the first substrate 7, such that the antenna array extends between the device chassis 14 and a rear or front section of the housing 15. As shown in Figs. 1 to 3 and 5, the antenna arrays 10, 12 may extend perpendicular to the main plane of the first substrate 7, but at a distance from the first substrate 7 such that the antenna array extends between the device chassis 14 and a side section of the housing 15. Furthermore, the antenna arrays 10, 12 may extend in a main plane of the second substrate 9, as shown in Fig. 6.

The connector 4 is configured to transmit at least one signal between the mmWave RFIC 8 and the mmWave antenna array 10 when the first mmWave module 2 and the second mmWave module 3 are interconnected. In one embodiment, the mmWave antenna array 10 comprises a plurality of mmWave antennas, and the connector 4 is configured to transmit a signal between the mmWave RFIC 8 and each one of the plurality of mmWave antennas. mmWave antenna array 12 may also comprise a plurality of mmWave antennas.

As shown in Figs. 1 to 6, connector 4 comprises at least a first connector element 5, associated with the first mmWave module 2.

In one embodiment, shown in Fig. 2, the first connector element 5 engages directly with the second substrate 9, e.g. by means of a female receptacle soldered to the first substrate 7 and a male counterpart formed within the second substrate 9, such as etched metal pads comprising signal and ground connections.

The connector 4 may further comprise a second connector element 6, associated with the second mmWave module 3, as shown in Figs. 1 and 3 to 6. The first mmWave module 2 engages with the second mmWave module 3 by means of the first connector element 5 engaging with the second connector element 6. The first connector element 5 may be soldered to the first substrate 7 and the second connector element 6 may be soldered to the second substrate 9. As shown in Figs. 1 and 3 to 6, the first connector element 5 may engage directly with the second connector element 6.

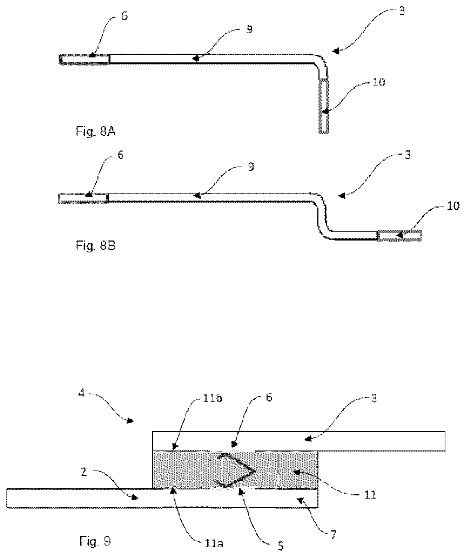

In one embodiment, shown in Fig. 9, the first mmWave module 2 engages with the second mmWave module 3 by means of a third connector element 11, the first connector element 5 and the second connector element 6 engaging through the third connector element 11. In one embodiment, the third connector element 11 is sandwiched between the first connector element 5 and the second connector element 6. Preferably, the third connector element 11 comprises a first section 11a and a second section 11b, the first section 11a engaging the first connector element 5 and the second section 11b engaging the second connector element 6.

The connector 4 may transmit the signal(s) by means of engagement between the first connector element 5 and the second substrate 9, as shown in Fig. 2. The connector 4 may transmit the signal(s) by means of engagement between the first connector element 5 and the second connector element 6, as shown in Figs 1 and 3 to 6. Furthermore, the connector 4 may transmit the signal(s) by means of engagement between the first section 11a of the third connector element 11 and the first connector element 5, and/or the second section 11b of the third connector element 11 and the second connector element 6, as shown in Fig. 9. The first section 11a and/or the second section 11b may comprise galvanic connecting members.

In one embodiment, the direct engagement comprises a galvanic connection provided by means of e.g. a zero insertion force (ZIF) connector, a coaxial connector, and/or a combination of connections. The ZIF connector may comprise of one or several coplanar structures. The coplanar structure(s) may be implemented by other means than ZIF such as mating springs integrated within a board-to-board connector.

In a further embodiment, the engagement comprises a non-galvanic connection provided by means of inductive or capacitive near field coupling between at least two of the first connector element 5, the second connector element 6, and the third connector element 11. The two connected elements should be arranged at a maximum distance of 1/10 of the operating wavelength of the antenna array 10, 12.

In one embodiment, at least one of the first connector element 5, the second connector element 6, and the third connector element 11 comprise a spring structure.

The various aspects and implementations have been described in conjunction with various embodiments herein. However, other variations to the disclosed embodiments can be understood and effected by those skilled in the art in practicing the claimed subject-matter, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measured cannot be used to advantage.

The reference signs used in the claims shall not be construed as limiting the scope.

## Claims

1. A mobile electronic device (13) comprising:
a device chassis (14);
a camera module (16);
a millimeter-wave, mmWave, assembly (1) comprising:
a first mmWave module (2) connected to the device chassis (14), wherein the first mmWave module (2) comprises a mmWave radio-frequency integrated circuit, RFIC (8),
a second mmWave module (3) comprising a second mmWave antenna array, and
a connector (4) configured to releasably interconnect the first mmWave module (2) and the second mmWave module (3); and
a housing (15) enclosing the device chassis (14), the camera module (16), and the mmWave assembly (1), **characterized in that** the second mmWave antenna array and the camera module (16) are connected.

2. The mobile electronic device (13) according to claim 1, wherein the second mmWave antenna array comprises at least one mmWave antenna, and wherein the connector (4) is configured to transmit at least one signal between the first mmWave module (2) and the at least one mmWave antenna.

3. The mobile electronic device (13) according to claim 1 or 2, wherein the first mmWave module (2) comprises a first substrate including a rigid printed circuit board, and wherein the second mmWave module (3) comprises a second substrate including a flexible circuit board.

4. The mobile electronic device (13) according to any one of claims 1-3, wherein the connector (4) comprises a first connector element (5) associated with the first mmWave module (2), a second connector element (6) associated with the second mmWave module (3), and a third connector element (11), and wherein the first connector element (5) and the second connector element (6) are configured to engage one another through the third connector element (11).

5. The mobile electronic device (13) according to claim 4, wherein the third connector element (11) comprises a first section (11a) and a second section (11b), wherein the first section (11a) is configured to engage the first connector element (5), and wherein the second section (11b) is configured to engage the second connector element (6).

6. The mobile electronic device (13) according to claim 5, wherein the connector (4) is configured to transmit at least one signal via engagement between at least one of:
the first connector element (5) and the second connector element (6);
the first section (11a) and the first connector element (5); or
the second section (11b) and the second connector element (6).

7. The mobile electronic device (13) according to claim 6, wherein the engagement comprises a galvanic connection.

8. The mobile electronic device (13) according to claim 6, wherein the engagement comprises a non-galvanic connection by inductive or capacitive near-field coupling.

9. The mobile electronic device (13) according to any one of claims 1-8, wherein the first mmWave module (2) comprises a first mmWave antenna array, and wherein the first mmWave antenna array comprises at least one mmWave antenna.

10. A method of assembling a mobile electronic device (13) having a device chassis (14), a camera module (16), and a millimeter-wave, mmWave, assembly (1), the method comprising:
connecting a first mmWave module (2) and a second mmWave module (3) of the mmWave assembly (1) to the device chassis (14), wherein the first mmWave module (2) comprises an mmWave radio-frequency integrated circuit, RFIC (8), and wherein the second mmWave module (3) comprises a second mmWave antenna array;
connecting the camera module (16) to the mmWave assembly (1);
enclosing the device chassis (14), the camera module (16), and the mmWave assembly (1) in a housing (15) of the mobile electronic device (13) such that the second mmWave antenna array and the camera module (16) are connected; and
engaging the mmWave assembly (1) with a connector (4) configured to releasably interconnect the first mmWave module (2) and the second mmWave module (3).

11. The method according to claim 10, wherein the second mmWave antenna array comprises at least one mmWave antenna.

12. The method according to claim 11, wherein the connector (4) is configured to transmit at least one signal between the first mmWave module (2) and the at least one mmWave antenna.

13. The method according to any one of claims 10-12, wherein the first mmWave module (2) comprises a first mmWave antenna array.

14. The method according to claim 13, wherein said first mmWave antenna array comprises at least one mmWave antenna.

15. The method according to any one of claims 10-14, wherein the connector (4) comprises a first connector element (5) associated with the first mmWave module (2).

## Patentansprüche

1. Mobile elektronische Vorrichtung (13), umfassend:
ein Vorrichtungsgestell (14);
ein Kameramodul (16);
eine Millimeterwellen-Anordnung, mmWave-Anordnung (1), umfassend:
ein erstes mmWave-Modul (2), das mit dem Vorrichtungsgestell (14) verbunden ist, wobei das erste mmWave-Modul (2) eine integrierte mmWave-Funkfrequenzschaltung, mmWave-RFIC (8), umfasst,
ein zweites mmWave-Modul (3), umfassend ein zweites mmWave-Antennenarray, und
einen Verbinder (4), der dazu konfiguriert ist, das erste mmWave-Modul (2) und das zweite mmWave-Modul (3) lösbar miteinander zu verbinden; und
ein Gehäuse (15), welches das Vorrichtungsgestell (14), das Kameramodul (16) und die mmWave-Anordnung (1) umschließt, **dadurch gekennzeichnet, dass** das zweite mmWave-Antennenarray und das Kameramodul (16) verbunden sind.

2. Mobile elektronische Vorrichtung (13) nach Anspruch 1, wobei das zweite mmWave-Antennenarray mindestens eine mmWave-Antenne umfasst und wobei der Verbinder (4) dazu konfiguriert ist, mindestens ein Signal zwischen dem ersten mmWave-Modul (2) und der mindestens einen mmWave-Antenne zu übertragen.

3. Mobile elektronische Vorrichtung (13) nach Anspruch 1 oder 2, wobei das erste mmWave-Modul (2) ein erstes Substrat, beinhaltend eine starre Leiterplatte, umfasst und wobei das zweite mmWave-Modul (3) ein zweites Substrat, beinhaltend eine flexible Leiterplatte, umfasst.

4. Mobile elektronische Vorrichtung (13) nach einem der Ansprüche 1-3, wobei der Verbinder (4) ein erstes Verbinderelement (5), das dem ersten mmWave-Modul (2) zugeordnet ist, ein zweites Verbinderelement (6), das dem zweiten mmWave-Modul (3) zugeordnet ist, und ein drittes Verbinderelement (11) umfasst und wobei das erste Verbinderelement (5) und das zweite Verbinderelement (6) dazu konfiguriert sind, über das dritte Verbinderelement (11) ineinander einzugreifen.

5. Mobile elektronische Vorrichtung (13) nach Anspruch 4, wobei das dritte Verbinderelement (11) einen ersten Teilabschnitt (11a) und einen zweiten Teilabschnitt (11b) umfasst, wobei der erste Teilabschnitt (11a) dazu konfiguriert ist, in das erste Verbinderelement (5) einzugreifen, und wobei der zweite Teilabschnitt (11b) dazu konfiguriert ist, in das zweite Verbinderelement (6) einzugreifen.

6. Mobile elektronische Vorrichtung (13) nach Anspruch 5, wobei der Verbinder (4) dazu konfiguriert ist, mindestens ein Signal durch einen Eingriff zwischen mindestens einem von Folgendem zu übertragen:
dem ersten Verbinderelement (5) und dem zweiten Verbinderelement (6);
dem ersten Teilabschnitt (11a) und dem ersten Verbinderelement (5); oder
dem zweiten Teilabschnitt (11b) und dem zweiten Verbinderelement (6) .

7. Mobile elektronische Vorrichtung (13) nach Anspruch 6, wobei der Eingriff eine galvanische Verbindung umfasst.

8. Mobile elektronische Vorrichtung (13) nach Anspruch 6, wobei der Eingriff eine nichtgalvanische Verbindung durch induktive oder kapazitive Nahfeldkopplung umfasst.

9. Mobile elektronische Vorrichtung (13) nach einem der Ansprüche 1-8, wobei das erste mmWave-Modul (2) ein erstes mmWave-Antennenarray umfasst und wobei das erste mmWave-Antennenarray mindestens eine mmWave-Antenne umfasst.

10. Verfahren zum Anordnen einer mobilen elektronischen Vorrichtung (13), die ein Vorrichtungsgestell (14), ein Kameramodul (16) und eine Millimeterwellen-Anordnung, mmWave-Anordnung (1), aufweist, wobei das Verfahren Folgendes umfasst:
Verbinden eines ersten mmWave-Moduls (2) und eines zweiten mmWave-Moduls (3) der mmWave-Anordnung (1) mit dem Vorrichtungsgestell (14), wobei das erste mmWave-Modul (2) eine integrierte mmWave-Funkfrequenzschaltung, mmWave-RFIC (8), umfasst und wobei das zweite mmWave-Modul (3) ein zweites mmWave-Antennenarray umfasst;
Verbinden des Kameramoduls (16) mit der mmWave-Anordnung (1);
derartiges Umschließen des Vorrichtungsgestells (14), des Kameramoduls (16) und der mmWave-Anordnung (1) in einem Gehäuse (15) der mobilen elektronischen Vorrichtung (13), dass das zweite mmWave-Antennenarray und das Kameramodul (16) verbunden sind;
und
Eingreifen der mmWave-Anordnung (1) in einen Verbinder (4), der dazu konfiguriert ist, das erste mmWave-Modul (2) und das zweite mmWave-Modul (3) lösbar miteinander zu verbinden.

11. Verfahren nach Anspruch 10, wobei das zweite mmWave-Antennenarray mindestens eine mmWave-Antenne umfasst.

12. Verfahren nach Anspruch 11, wobei der Verbinder (4) dazu konfiguriert ist, mindestens ein Signal zwischen dem ersten mmWave-Modul (2) und der mindestens einen mmWave-Antenne zu übertragen.

13. Verfahren nach einem der Ansprüche 10-12, wobei das erste mmWave-Modul (2) ein erstes mmWave-Antennenarray umfasst.

14. Verfahren nach Anspruch 13, wobei das erste mmWave-Antennenarray mindestens eine mmWave-Antenne umfasst.

15. Verfahren nach einem der Ansprüche 10-14, wobei der Verbinder (4) ein erstes Verbinderelement (5) umfasst, das dem ersten mmWave-Modul (2) zugeordnet ist.

## Revendications

1. Dispositif électronique mobile (13) comprenant :
un châssis de dispositif (14) ;
un module de caméra (16) ;
un ensemble à ondes millimétriques, mmWave, (1) comprenant :
un premier module mmWave (2) connecté au châssis de dispositif (14), dans lequel le premier module mmWave (2) comprend un circuit intégré radiofréquence mmWave, RFIC (8),
un second module mmWave (3) comprenant un second réseau d'antennes mmWave, et
un connecteur (4) configuré pour interconnecter de manière libérable le premier module mmWave (2) et le second module mmWave (3) ; et
un boîtier (15) renfermant le châssis de dispositif (14), le module de caméra (16) et l'ensemble mmWave (1), **caractérisé en ce que** le second réseau d'antennes mmWave et le module de caméra (16) sont connectés.

2. Dispositif électronique mobile (13) selon la revendication 1, dans lequel le second réseau d'antennes mmWave comprend au moins une antenne mmWave, et dans lequel le connecteur (4) est configuré pour transmettre au moins un signal entre le premier module mmWave (2) et l'au moins une antenne mmWave.

3. Dispositif électronique mobile (13) selon la revendication 1 ou 2, dans lequel le premier module mmWave (2) comprend un premier substrat comportant une carte de circuit imprimé rigide, et dans lequel le second module mmWave (3) comprend un second substrat comportant une carte de circuit imprimé flexible.

4. Dispositif électronique mobile (13) selon l'une quelconque des revendications 1 à 3, dans lequel le connecteur (4) comprend un premier élément de connecteur (5) associé au premier module mmWave (2), un deuxième élément de connecteur (6) associé au second module mmWave (3) et un troisième élément de connecteur (11), et dans lequel le premier élément de connecteur (5) et le deuxième élément de connecteur (6) sont configurés pour entrer en contact l'un avec l'autre par l'intermédiaire du troisième élément de connecteur (11).

5. Dispositif électronique mobile (13) selon la revendication 4, dans lequel le troisième élément de connecteur (11) comprend une première section (11a) et une seconde section (11b), dans lequel la première section (11a) est configurée pour entrer en contact avec le premier élément de connecteur (5), et dans lequel la seconde section (11b) est configurée pour entrer en contact avec le deuxième élément de connecteur (6).

6. Dispositif électronique mobile (13) selon la revendication 5, dans lequel le connecteur (4) est configuré pour transmettre au moins un signal par l'intermédiaire de l'entrée en contact avec au moins l'un des éléments suivants :
le premier élément de connecteur (5) et le deuxième élément de connecteur (6) ;
la première section (11a) et le premier élément de connecteur (5) ; ou
la seconde section (11b) et le deuxième élément de connecteur (6).

7. Dispositif électronique mobile (13) selon la revendication 6, dans lequel la mise en contact comprend une connexion galvanique.

8. Dispositif électronique mobile (13) selon la revendication 6, dans lequel la mise en contact comprend une connexion non galvanique par couplage de champ proche inductif ou capacitif.

9. Dispositif électronique mobile (13) selon l'une quelconque des revendications 1 à 8, dans lequel le premier module mmWave (2) comprend un premier réseau d'antennes mmWave, et dans lequel le premier réseau d'antennes mmWave comprend au moins une antenne mmWave.

10. Procédé d'assemblage d'un dispositif électronique mobile (13) ayant un châssis de dispositif (14), un module de caméra (16) et un ensemble à ondes millimétriques, mmWave (1), le procédé comprenant :
la connexion d'un premier module mmWave (2) et d'un second module mmWave (3) de l'ensemble mmWave (1) au châssis de dispositif (14), dans lequel le premier module mmWave (2) comprend un circuit intégré radiofréquence mmWave, RFIC (8), et dans lequel le second module mmWave (3) comprend un second réseau d'antennes mmWave ;
la connexion du module de caméra (16) à l'ensemble mmWave (1) ; le renfermement du châssis de dispositif (14), le module de caméra (16) et l'ensemble mmWave (1) dans un boîtier (15) du dispositif électronique mobile (13) de sorte que le deuxième réseau d'antennes mmWave et le module de caméra (16) sont connectés ;
et
l'entrée en contact de l'ensemble mmWave (1) avec un connecteur (4) configuré pour interconnecter de manière libérable le premier module mmWave (2) et le second module mmWave (3).

11. Procédé selon la revendication 10, dans lequel le second réseau d'antennes mmWave comprend au moins une antenne mmWave.

12. Procédé selon la revendication 11, dans lequel le connecteur (4) est configuré pour transmettre au moins un signal entre le premier module mmWave (2) et l'au moins une antenne mmWave.

13. Procédé selon l'une quelconque des revendications 10 à 12, dans lequel le premier module mmWave (2) comprend un premier réseau d'antennes mmWave.

14. Procédé selon la revendication 13, dans lequel ledit premier réseau d'antennes mmWave comprend au moins une antenne mmWave.

15. Procédé selon l'une quelconque des revendications 10 à 14, dans lequel le connecteur (4) comprend un premier élément de connecteur (5) associé au premier module mmWave (2).
